# EUROPEAN PATENT APPLICATION

(11) **EP 4 646 026 A1**
(43) Date of publication of application: **05.11.2025**
(21) Application number: 23921365.5
(22) Date of filing: 20.12.2023
(51) Int. Cl.: H05B 3/02, B29C 65/08, H05B 3/20, H05K 1/02, H05K 3/10

(54) **EMBEDDED TRACE SUBSTRATE, PRODUCTION METHOD FOR SAME, AND EMBEDDED TRACE SUBSTRATE-INTEGRATED MOLDED ARTICLE**

(30) Priority: 08.02.2023 JP 2023017225
(71) Applicant: NISSHA CO., LTD., Kyoto-shi, Kyoto 604-8551 (JP)
(72) Inventor: KUROSAKI, Toshifumi, Kyoto-shi, Kyoto 604-8551 (JP); YOKOYAMA, Takashi, Kyoto-shi, Kyoto 604-8551 (JP)
(74) Representative: Isarpatent
(86) International application number: PCT/JP2023/045627
(87) International publication number: WO 2024/166547

(57) **Abstract**

[Problem] The purpose of the present invention is to provide an embedded trace substrate that is less likely to experience reductions in conductivity and a production method for an embedded trace substrate with which it is possible to easily produce such an embedded trace substrate. An object of the present invention is also to provide an embedded trace substrate-integrated molded article using an embedded trace substrate that is less likely to experience reductions in conductivity.

[Solution] An embedded trace substrate according to the present invention includes: a film; a circuit that includes a thin metal wire and that has a functional portion having an arbitrary pattern, a first wiring portion led out from one end of both ends of the functional portion, a second wiring portion led out from another end of both ends of the functional portion, and folded-back portions extending in a direction away from the functional portion from the first wiring portion and the second wiring portion, respectively, and folded back so as to be parallel to the film, the functional portion, the first wiring portion, and the second wiring portion being embedded in the film; and two electrode pads respectively fixed on the first wiring portion and the second wiring portion and having upper surfaces to which the folded-back portions are electrically connected.

## Description

### Technical Field

The present invention relates to an embedded trace substrate, a production method for the same, and an embedded trace substrate-integrated molded article.

### Background Art

A film heater in which one thin metal wire is embedded in a film in an arbitrary pattern is known (see, for example, Patent Literature 1). Referring to Fig. 13, such a film heater 100 includes a film 200, a joining layer 800 provided on the film 200, and a circuit 400 including one coated thin metal wire 300 embedded in the joining layer 800. The circuit 400 includes a connection terminal portion 410, a wiring portion 420 extending from the connection terminal portion 410, and a heater portion 430 extending from the wiring portion 420 and having an arbitrary pattern. The circuit 400 is embedded by melting a contact surface of the joining layer 800 with the thin metal wire 300 through the application of ultrasonic vibration.

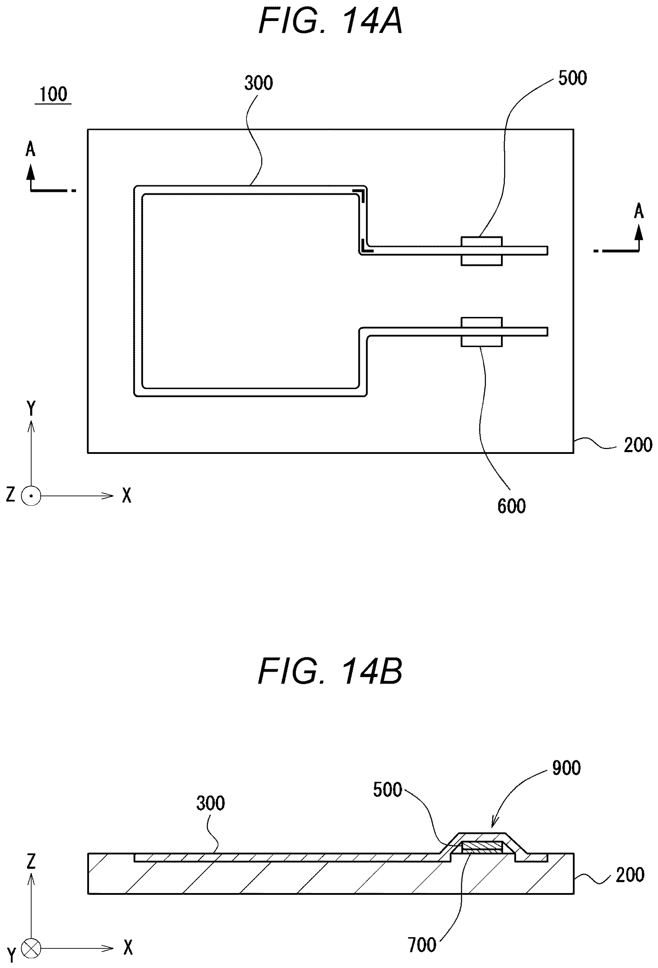

In order to take out the connection terminal portion 410 to the outside, a method for welding the connection terminal portion 410 and an electrode pad (not illustrated) using soldering, fusing, or the like is conceivable. When this method is used, the efficiency in connection work is more improved by placing the electrode pad on the film 200 and then placing the connection terminal portion 410 thereon rather than by placing the electrode pad on the connection terminal portion 410. For example, referring to Fig. 14, a method for embedding the coated thin metal wire 300 into the film 200 so as to extend across electrode pad 500, 600 fixed on the film 200 with an adhesive layer 700 therebetween and welding the electrode pad 500, 600 with the thin metal wire 300 is conceivable.

### Citation List

### Patent Literature

Patent Literature 1: JP 2020-161458 A

### Summary of Invention

### Technical Problem

The thin metal wire 300 is embedded in the film 200 so as to extend across the electrode pad 500, 600. Therefore, tensile stress (tension) is applied in the X direction to the thin metal wire 300 at a position where the thin metal wire 300 extends across the electrode pad 500, 600, and the thin metal wire 300 is welded in this state. The film heater 100 has the following problem. Specifically, when the film 200 shrinks in the X direction and/or the Y direction depending on the use environment of the film heater 100, the thin metal wire 300 does not follow the shrinkage, so that stress is generated in a weld portion 900 between the electrode pad 500, 600 and the thin metal wire 300, and as a result, the weld portion 900 is peeled off, leading to a reduction in conductivity.

The present invention has been made to solve the above-described problem, and an object of the present invention is to provide an embedded trace substrate that is less likely to experience reductions in conductivity, and a production method for an embedded trace substrate with which it is possible to easily produce such an embedded trace substrate. An object of the present invention is also to provide an embedded trace substrate-integrated molded article using an embedded trace substrate that is less likely to experience reductions in conductivity.

### Solution to Problem

According to a first invention for achieving the above-mentioned objects, an embedded trace substrate includes: a film; a circuit that includes a thin metal wire disposed on a first main surface of the film and that has a functional portion having an arbitrary pattern, a first wiring portion led out from one end of both ends of the functional portion, a second wiring portion led out from another end of both ends of the functional portion, and folded-back portions extending in a direction away from the functional portion from the first wiring portion and the second wiring portion, respectively, and folded back so as to be parallel to the first main surface of the film, the functional portion, the first wiring portion, and the second wiring portion being embedded in the film; and two electrode pads respectively fixed on the first wiring portion and the second wiring portion and having upper surfaces to which the folded-back portions are electrically connected.

In the embedded trace substrate, the functional portion, the first wiring portion, and the second wiring portion of the circuit are embedded in the first main surface of the film, and the folded-back portions are folded back without being embedded in the film and connected to the upper surfaces of the electrode pads. That is, stress is less likely to be applied to the thin metal wire at a connection portion, and thus, even if the film shrinks, the connection portion is less likely to peel off, whereby the conductivity is less likely to decrease.

According to a second invention for achieving the above-mentioned objects, an embedded trace substrate includes: a film; two circuits each including a thin metal wire disposed on a first main surface of the film, the two circuits including a first functional portion and a second functional portion, respectively, which are arranged in parallel to each other and each of which has an arbitrary pattern, a first wiring portion led out from one end of both ends of the first functional portion, a second wiring portion led out from another end of both ends of the first functional portion, a third wiring portion led out from one end of both ends of the second functional portion, a fourth wiring portion led out from another end of both ends of the second functional portion, and a first folded-back portion, a second folded-back portion, a third folded-back portion, and a fourth folded-back portion that extend from the first wiring portion, the second wiring portion, the third wiring portion, and the fourth wiring portion, respectively, in a direction away from the first functional portion and the second functional portion, and that are folded back so as to be parallel to the first main surface of the film, the first functional portion, the second functional portion, the first wiring portion, the second wiring portion, the third wiring portion, and the fourth wiring portion being embedded in the film; a first electrode pad fixed on both the first wiring portion and the third wiring portion and having an upper surface to which the first folded-back portion and the third folded-back portion are electrically connected; and a second electrode pad fixed on both the second wiring portion and the fourth wiring portion and having an upper surface to which the second folded-back portion and the fourth folded-back portion are electrically connected.

According to a third invention, in the embedded trace substrate according to the second invention, end portions respectively extending from the first wiring portion and the third wiring portion or end portions respectively extending from the second wiring portion and the fourth wiring portion are joined to each other.

According to a fourth invention, in the embedded trace substrate according to any one of the first to third inventions, the thin metal wire is covered with an insulating coating layer, the thin metal wire at the folded-back portions is fully exposed, and the thin metal wire that is exposed is electrically connected to the electrode pads.

According to a fifth invention, in the embedded trace substrate according to any one of the first to third inventions, the thin metal wire is covered with an insulating coating layer, the thin metal wire is exposed from a part of the insulating coating layer at the folded-back portions, and the thin metal wire that is exposed is electrically connected to the electrode pads using a conductive joint material.

According to a sixth invention for achieving the above-mentioned objects, an embedded trace substrate-integrated molded article includes: a molded body having a three-dimensional shape; and the embedded trace substrate according to any one of the first to third inventions, the embedded trace substrate being integrated along the three-dimensional shape and including at least two of the electrode pads exposed from the molded body.

According to a seventh invention for achieving the above-mentioned objects, a production method for an embedded trace substrate includes: a preparation step of preparing a film; a circuit formation step of forming a circuit that includes a thin metal wire disposed on a first main surface of the film and that has a functional portion having an arbitrary pattern, a first wiring portion led out from one end of both ends of the functional portion, a second wiring portion led out from another end of both ends of the functional portion, and a first end portion and a second end portion that extend in a direction away from the functional portion from the first wiring portion and the second wiring portion, respectively, the functional portion, the first wiring portion, and the second wiring portion being embedded in the first main surface of the film using an ultrasonic welding machine; a fixing step of fixing electrode pads on the first wiring portion and the second wiring portion, respectively; and a connection step of folding back the first end portion and the second end portion to upper surfaces of the electrode pads so as to be parallel to the first main surface of the film and electrically connecting the first end portion and the second end portion to the electrode pads.

With the production method described above, the functional portion, the first wiring portion, and the second wiring portion are embedded in the first main surface of the film, and then, the first end portion and the second end portion that are not embedded in the film are folded back and connected to the upper surfaces of the electrode pads. That is, the connection is achieved without applying stress to the thin metal wire at the connection portion, and thus, even if the film shrinks, the connection portion is less likely to peel off, whereby the conductivity is less likely to decrease.

According to an eighth invention, in the production method for an embedded trace substrate according to the seventh invention, the ultrasonic welding machine includes a horn that applies ultrasonic vibration to melt a contact surface of the film with the thin metal wire and embed the thin metal wire in the first main surface of the film, and the thin metal wire that passes through an inside of the horn and is continuously drawn out from a tip of the horn onto the first main surface of the film, and the circuit formation step includes: a step of drawing out the thin metal wire by a predetermined length from the horn as the first end portion that is not embedded in the film; a step of forming the first wiring portion by further drawing out the thin metal wire by a predetermined length from an end point of the first end portion that has been drawn out and embedding the thin metal wire in the first main surface of the film; a step of forming the functional portion by drawing out the thin metal wire from the horn by a predetermined length and embedding, in an arbitrary pattern, the thin metal wire in the first main surface of the film from an end point of the first wiring portion that has been embedded; a step of forming the second wiring portion by drawing out the thin metal wire from the horn by a predetermined length and embedding the thin metal wire which extends from an end point of the functional portion that has been embedded in the first main surface of the film; a step of drawing out the thin metal wire by a predetermined length from an end point of the second wiring portion that has been embedded as the second end portion that is not embedded in the film; and a step of cutting the thin metal wire at an end point of the second end portion that has been drawn out.

According to a ninth invention, in the production method for an embedded trace substrate according to the seventh or eighth invention, the thin metal wire used in the circuit formation step is covered with an insulating coating layer, and the connection step includes: a step of folding back the first end portion and the second end portion so that the insulating coating layer at the first end portion and the second end portion is in contact with the upper surfaces of the electrode pads; and a step of melting the insulating coating layer at the first end portion and the second end portion by heat to fully expose the thin metal wire and electrically connecting the thin metal wire that has been exposed with the upper surfaces of the electrode pads.

According to a tenth invention, in the production method for an embedded trace substrate according to the seventh or eighth invention, the thin metal wire used in the circuit formation step is covered with an insulating coating layer, and the connection step includes: a step of removing a part of the insulating coating layer at the first end portion and the second end portion in advance; a step of folding back the first end portion and the second end portion so that the first end portion and the second end portion are in contact with the upper surfaces of the electrode pads; and a step of electrically connecting the thin metal wire with the electrode pads using a conductive joint material.

### Advantageous Effects of Invention

The embedded trace substrate and the embedded trace substrate-integrated molded article according to the present invention are less likely to experience reductions in conductivity. According to the production method for an embedded trace substrate according to the present invention, it is possible to easily obtain an embedded trace substrate that is less likely to experience reductions in conductivity.

### Brief Description of Drawings

Fig. 1(a) is a schematic plan view illustrating an embodiment of an embedded trace substrate. Fig. 1(b) is a cross-sectional view taken along line A-A in Fig. 1(a).
Fig. 2 is a schematic cross-sectional view illustrating an example of a coated thin metal wire.
Fig. 3 is a schematic cross-sectional view illustrating an example of connection between a thin metal wire and an electrode pad.
Fig. 4 is a schematic plan view illustrating another embodiment of an embedded trace substrate.
Fig. 5(a) is a schematic plan view illustrating another embodiment of an embedded trace substrate. Fig. 5 (b) is a partially enlarged view of Fig. 5(a).
Fig. 6 is a schematic plan view illustrating another example of a circuit.
Fig. 7 is a schematic plan view illustrating another example of a circuit.
Fig. 8(a) is a schematic perspective view illustrating an embodiment of an embedded trace substrate-integrated molded article. Fig. 8(b) is a cross-sectional view taken along line A-A in Fig. 8(a).
Fig. 9 is a schematic cross-sectional view illustrating another example of an embedded trace substrate-integrated molded article.
Fig. 10 is a schematic perspective view illustrating an embodiment of a production method for an embedded trace substrate.
Fig. 11 is a schematic cross-sectional view illustrating a state in which a thin metal wire passes through the inside of a horn and is embedded in a film.
Fig. 12 is a schematic perspective view illustrating another example of a production method for an embedded trace substrate.
Fig. 13(a) is a schematic plan view illustrating a conventional film heater. Fig. 13(b) is a cross-sectional view taken along line A-A in Fig. 13(a).
Fig. 14(a) is a schematic plan view illustrating another example of a conventional film heater. Fig. 14(b) is a cross-sectional view taken along line A-A in Fig. 14 (a) .

### Description of Embodiments

### (First embodiment of embedded trace substrate)

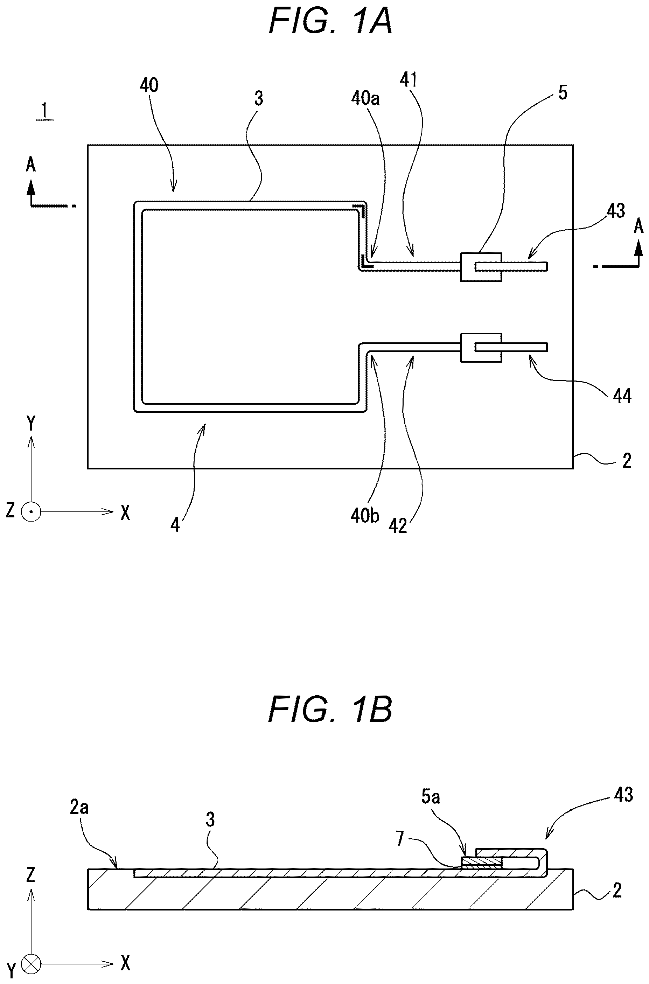

Referring to Fig. 1(a), an embedded trace substrate 1 includes a film 2, a circuit 4 including one thin metal wire 3 disposed on a first main surface 2a of the film 2, a first electrode pad 5, and a second electrode pad 6.

The film 2 can have any shape, and has a rectangular shape in the present embodiment. As the film 2, a transparent film, an opaque film, or a colored transparent film can be used. Examples of a material usable for the film 2 include thermoplastic resins such as an ethylene-based resin, a propylene-based resin, a polyolefin-based resin, a thermoplastic polyester-based resin, a polyamide-based resin, polyvinyl chloride, polycarbonate, and an ABS resin. Two or more kinds of the materials may be used. Inorganic fine powder, an organic filler, a dispersant, an antioxidant, a compatibilizer, an ultraviolet stabilizer, an antiblocking agent, an antistatic agent, or the like can be appropriately added to the film 2. The thickness of the film 2 is, for example, 0.05 mm to 1 mm.

The circuit 4 includes a functional portion 40 having an arbitrary pattern, a first wiring portion 41 led out from one end 40a of both ends of the functional portion 40, a second wiring portion 42 led out from another end 40b of both ends of the functional portion 40, a first folded-back portion 43, and a second folded-back portion 44. The first electrode pad 5 and the second electrode pad 6 are fixed onto the first wiring portion 41 and the second wiring portion 42, respectively, with an adhesive layer 7 therebetween, and the folded-back portions 43 and 44 are electrically connected to upper surfaces 5a and 6a of the electrode pads 5 and 6, respectively. In other words, the first electrode pad 5 is positioned between the first wiring portion 41 and the first folded-back portion 43, and the second electrode pad 6 is positioned between the second wiring portion 42 and the second folded-back portion 44. The folded-back portions 43 and 44 extend in a direction (+X direction in Fig. 1) away from the functional portion 40 from the first wiring portion 41 and the second wiring portion 42, respectively, and are folded back so as to be parallel to the first main surface 2a of the film 2 (see Fig. 1(b)).

The functional portion 40, the first wiring portion 41, and the second wiring portion 42 are embedded in the first main surface 2a of the film 2. The folded-back portions 43 and 44 are not embedded in the film 2.

In the present embodiment, the functional portion 40 is a heat generating portion, and the embedded trace substrate 1 is a film heater. For example, a current is generated in the circuit 4 including the thin metal wire 3 by applying a positive voltage to the first electrode pad 5 and a negative voltage to the second electrode pad 6, so that the functional portion 40 generates heat. The functional portion 40 has both ends 40a and 40b connected to the first wiring portion 41 and the second wiring portion 42, respectively, and has a loop-like pattern shape. More specifically, the functional portion 40 has a pattern shape that extends in the +Y direction from the connection portion 40a with the first wiring portion 41, and then extends in the -X direction, the -Y direction, the +X direction, and the +Y direction to reach the connection portion 40b with the second wiring portion 42. As described above, the functional portion 40 has the connection portion 40a with the first wiring portion 41 and the connection portion 40b with the second wiring portion 42, and has an arbitrary pattern extending from the connection portions 40a and 40b in the XY plane.

For the thin metal wire 3, for example, a material having conductivity such as copper, iron, gold, copper nickel, nickel chromium, or iron nickel chromium can be used. From the viewpoint of electric resistance, durability, and cost, it is preferable to use copper or a copper alloy obtained by combining zinc, lead, tin, silver, aluminum, nickel, beryllium, zirconium, or the like alone with copper or combining a plurality of the above-mentioned materials with copper. The diameter of the thin metal wire 3 is, for example, 0.01 mm to 0.5 mm. The thin metal wire 3 can be made less noticeable by reducing the diameter as much as possible to, for example, 0.01 mm to 0.2 mm.

The electrode pads 5 and 6 serve as terminal portions of the embedded trace substrate 1, and thus are fixed to a peripheral portion on the first main surface 2a of the film 2. In Fig. 1(a), the electrode pads 5 and 6 are aligned in the Y direction on the first main surface 2a of the film 2 at the peripheral edge portion. More specifically, the electrode pads 5 and 6 are aligned in the Y direction along one side of the film 2 parallel to the Y direction. As the electrode pads 5 and 6, for example, a material having conductivity such as copper, phosphor bronze, brass, a Corson alloy, nickel, or molybdenum can be used. A material obtained by plating the above-mentioned material as a base material with nickel, tin, gold, silver, copper, or the like may be used. The size of the electrode pads 5 and 6 is, for example, 5 mm×10 mm. The thickness is, for example, 0.1 mm.

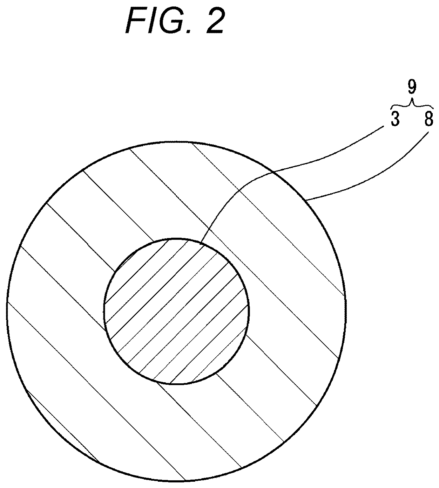

Referring to Fig. 2, the circuit 4 may be composed of a conductive wire 9 including a thin metal wire 3 and an insulating coating layer 8 coating the thin metal wire 3. The insulating coating layer 8 is an insulating resin, and examples of usable resins include polyester, polyethylene, polyurethane, polyvinyl chloride, polyamide, polyimide, polyesterimide, polyamideimide, and fluororesin. The diameter of the conductive wire 9 is, for example, 0.05 mm to 0.3 mm.

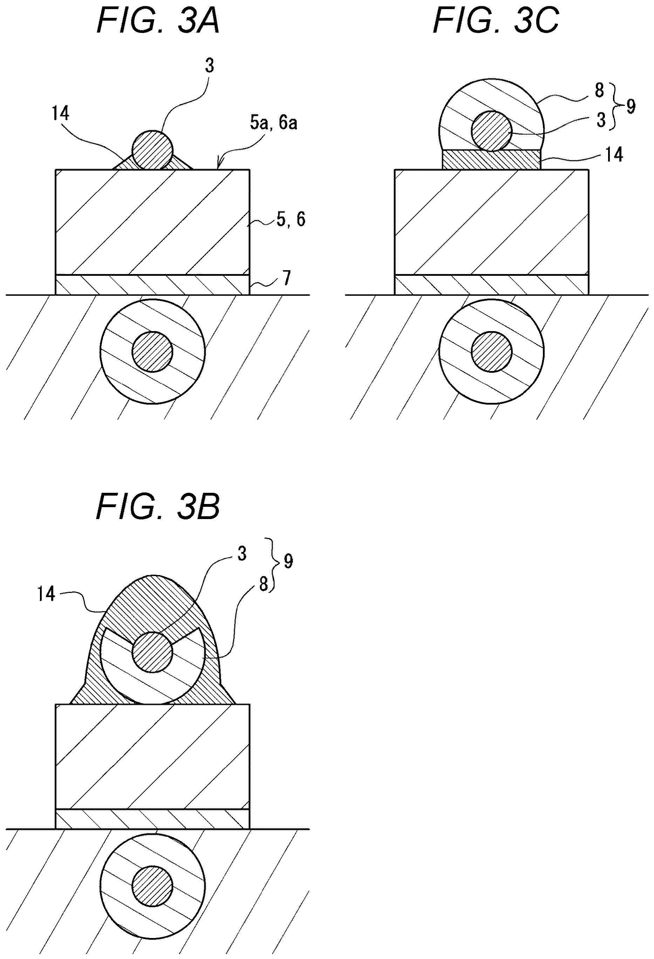

Referring to Fig. 3(a), in the embedded trace substrate 1, the thin metal wire 3 may be fully exposed at the folded-back portions 43 and 44, and the exposed parts of the thin metal wire 3 and the upper surfaces 5a and 6a of the electrode pads 5 and 6 may be electrically connected with a conductive joint material 14 interposed therebetween. As the conductive joint material 14, a solder, a brazing filling material, a conductive adhesive, or the like, for example, can be used. Further, the exposed parts of the thin metal wire 3 and the upper surfaces 5a and 6a of the electrode pads 5 and 6 can be electrically connected without using the conductive joint material 14. Examples of such a connection method include a welding method such as resistance welding, ultrasonic welding, or laser welding, and a thermocompression bonding method.

Referring to Figs. 3(b) and 3(c), in the embedded trace substrate 1, a part of the metal wire 3 may be exposed from the insulating coating layer 8 at the folded-back portions 43 and 44, and the exposed parts of the thin metal wire 3 and the upper surfaces 5a and 6a of the electrode pads 5 and 6 may be electrically connected using the conductive joint material 14. In Fig. 3(b), the upper part of the insulating coating layer 8 is removed to expose the thin metal wire 3, and the lower part of the insulating coating layer 8 is in contact with the upper surface 5a, 6a of the electrode pad 5, 6. By providing the conductive joint material 14 (for example, solder) so as to cover the conductive wire 9 at the folded-back portions 43 and 44, the exposed parts of the thin metal wire 3 and the upper surfaces 5a and 6a of the electrode pads 5 and 6 can be electrically connected. In Fig. 3(c), the lower part of the insulating coating layer 8 is removed to expose the thin metal wire 3, and the exposed parts of the thin metal wire 3 and the upper surfaces 5a and 6a of the electrode pads 5 and 6 are electrically connected using the conductive joint material 14.

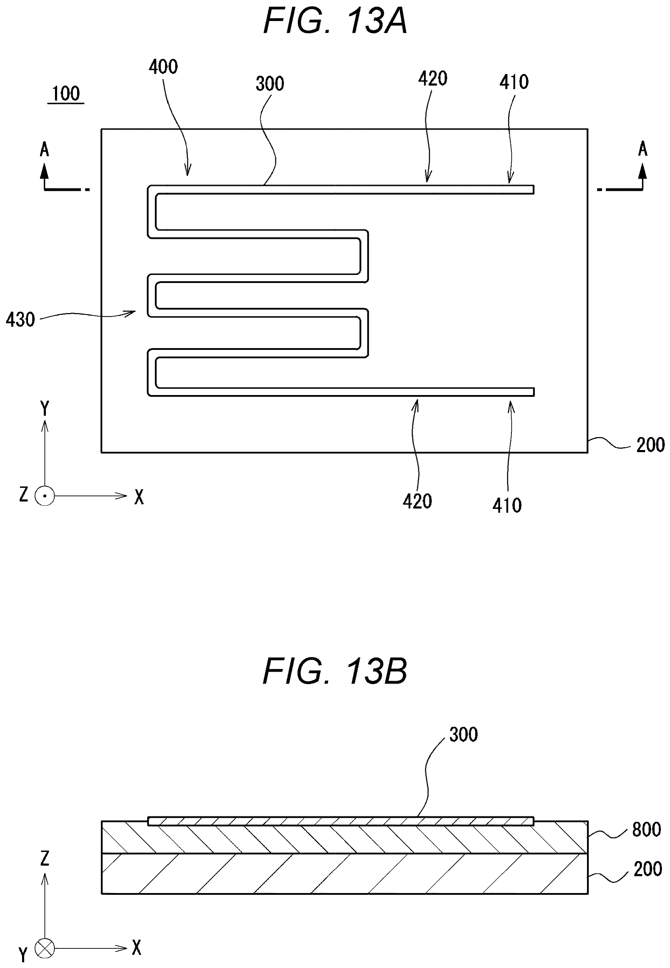

Referring to Fig. 13(b), in the conventional film heater 100, the thin metal wire 300 embedded in the film 200 is located on the left and right of the electrode pad 500, and the thin metal wire 300 not embedded in the film 200 is electrically connected to the upper surface of the electrode pad 500. That is, the thin metal wire 300 is embedded in the film 200 across the electrode pad 500. A dimensional difference due to a temperature change is generated by a difference in linear expansion coefficient between the thin metal wire 300 and the film 200. Therefore, shearing stress (shear stress) is generated between the embedded thin metal wire 300 and the film 200, and tensile stress is generated in the thin metal wire 3 that extends across the electrode pad 500. On the other hand, in the embedded trace substrate 1, the thin metal wire 3 embedded in the first main surface 2a of the film 2 is under the electrode pad 5, and the thin metal wire 3 (folded-back portion 43) not embedded in the film 2 extends from the first wiring portion 41, is simply folded back, and is electrically connected to the upper surface 5a of the electrode pad 5 as illustrated in Fig. 1(b). That is, stress is less likely to be applied to the thin metal wire 3 (folded-back portion 43) connected to the upper surface 5a of the electrode pad 5 than in the conventional case (Fig. 13(b)). Therefore, even if the film 2 shrinks, the connection portion is less likely to peel off, whereby the conductivity is less likely to decrease.

### (Second embodiment of embedded trace substrate)

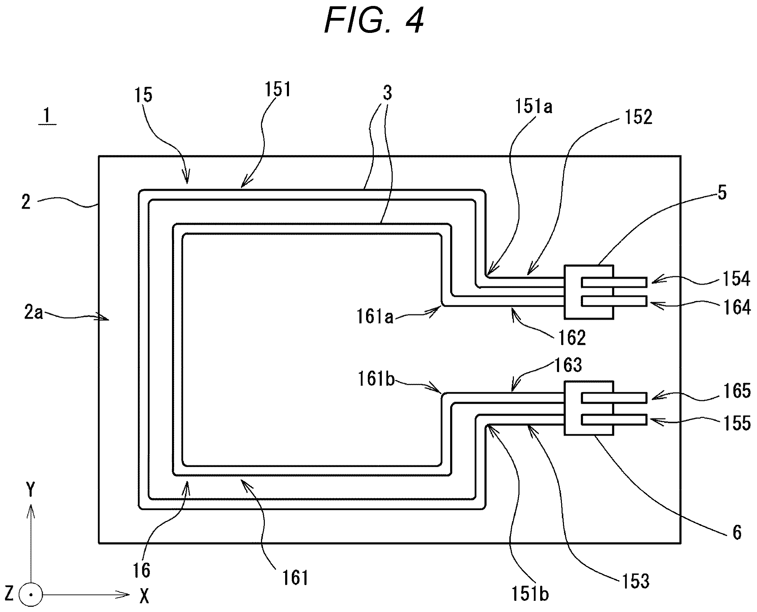

Referring to Fig. 4, an embedded trace substrate 1 according to the second embodiment includes a film 2, a first circuit 15 and a second circuit 16 each including one thin metal wire 3 disposed on a first main surface 2a of the film 2, a first electrode pad 5, and a second electrode pad 6. In the embedded trace substrate 1 according to the second embodiment, unlike the first embodiment, two thin metal wires 3 constitute circuits 15 and 16, respectively, two folded-back portions 154 and 164 are connected to the first electrode pad 5, and two folded-back portions 155 and 165 are connected to the second electrode pad 6.

The first circuit 15 includes a first functional portion 151, a first wiring portion 152 led out from one end 151a of both ends of the first functional portion 151, a second wiring portion 153 led out from another end 151b of both ends of the first functional portion 151, and the first folded-back portion 154 and the second folded-back portion 155 which extend in a direction (+X direction) away from the first functional portion 151 from the first wiring portion 152 and the second wiring portion 153, respectively, and are folded back so as to be parallel to the first main surface 2a of the film 2. The first functional portion 151 has a loop-shaped pattern having one end 151a as a start point and the other end 151b as a terminal point. In the first circuit 15, the first functional portion 151, the first wiring portion 152, and the second wiring portion 153 are embedded in the first main surface 2a of the film 2, and the first folded-back portion 154 and the second folded-back portion 155 are not embedded.

The second circuit 16 which is disposed inside the first circuit 15 includes a second functional portion 161, a third wiring portion 162 led out from one end 161a of both ends of the second functional portion 161, a fourth wiring portion 163 led out from another end 161b of both ends of the second functional portion 161, and a third folded-back portion 164 and a fourth folded-back portion 165 which extend in a direction (+X direction) away from the second functional portion 161 from the third wiring portion 162 and the fourth wiring portion 163, respectively, and are folded back so as to be parallel to the first main surface 2a of the film 2. The second functional portion 161 has a loop-shaped pattern having one end 161a as a start point and the other end 161b as a terminal point. In the second circuit 16, the second functional portion 161, the third wiring portion 162, and the fourth wiring portion 163 are embedded in the first main surface 2a of the film 2, and the third folded-back portion 164 and the fourth folded-back portion 165 are not embedded.

A current is generated in the counterclockwise direction in the first circuit 15 and the second circuit 16 by applying a positive voltage to the first electrode pad 5 and a negative voltage to the second electrode pad 6. That is, the first circuit and the second circuit 16 are arranged in parallel.

Note that, as in the first embodiment, a conductive wire 9 obtained by coating the thin metal wire 3 with an insulating coating layer 8 may be used. As a method for connecting the electrode pads 5 and 6 and the folded-back portions 154 and 155 and the folded-back portions 164 and 165, the same method as in the first embodiment can be used.

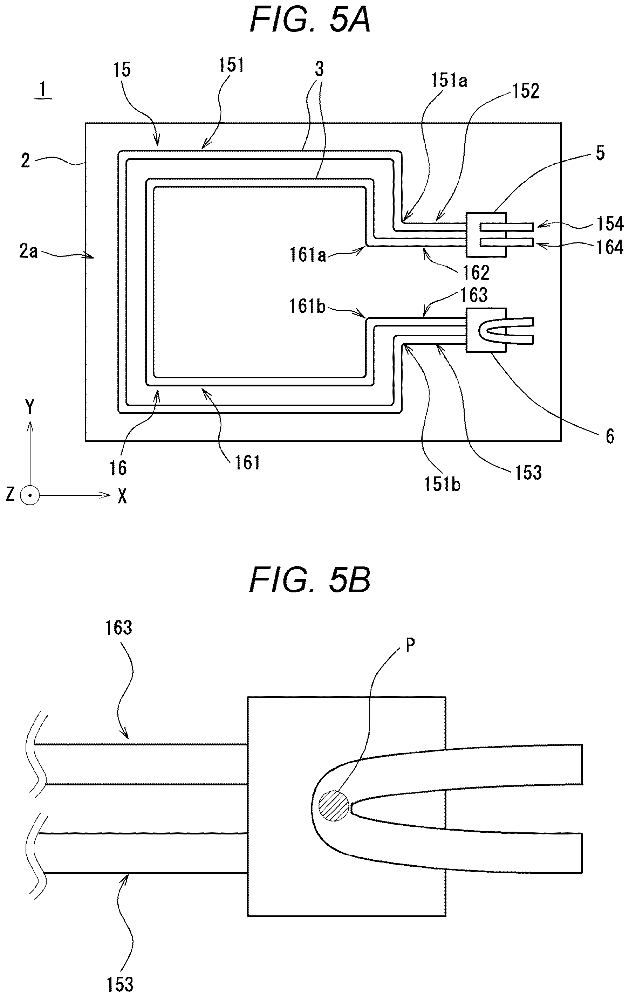

Referring to Fig. 5, in the embedded trace substrate 1 according to the second embodiment, end portions extending from the second wiring portion 153 and the fourth wiring portion 163 may be joined to each other. More specifically, referring to Fig. 5(b), the end portion extending from the second wiring portion 153 and the end portion extending from the fourth wiring portion 163 are joined at a point P. With reference to Fig. 4, examples of a method for joining the end portions include a method for joining the end portion of the second folded-back portion 155 and the end portion of the fourth folded-back portion 165 before or at the time of connection to the second electrode pad 6. Alternatively, by forming the first circuit 15 and the second circuit 16 with one thin metal wire 3, the folded-back portions to be connected to the second electrode pad 6 can be provided in a state of being joined in advance. The folded-back portion to be connected to the second electrode pad 6 is electrically connected to the second electrode pad 6 at a point P.

### (Common first modification)

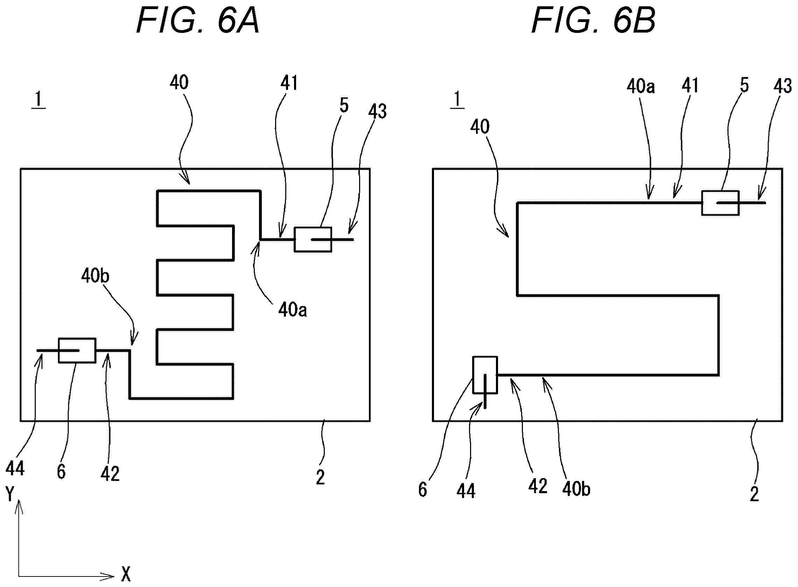

In the first and second embodiments, the electrode pads 5 and 6 are aligned in the Y direction, but the positions of the electrode pads 5 and 6 are not limited thereto. For example, the electrode pad 5 and the electrode pad 6 may be disposed at different positions as illustrated in Figs. 6(a) and 6(b). In Fig. 6(a), the folded-back portion 43 extends in a direction (+X direction) away from the functional portion 40 from the first wiring portion 41 and is folded back, and the folded-back portion 44 extends in a direction (-X direction) away from the functional portion 40 from the second wiring portion 42 and is folded back. The functional portion 40 has a meander shape. In Fig. 6(b), the folded-back portion 43 extends in a direction (+X direction) away from the functional portion 40 from the first wiring portion 41 and is folded back, and the folded-back portion 44 changes its direction to extend in the -Y direction from the second wiring portion 42 and is folded back. As described above, in addition to the case where the folded-back portion extends in the X direction with respect to the functional portion 40, the case in which the folded-back portion extends in the Y direction with respect to the functional portion 40 is also included in the feature of "extending in a direction away from the functional portion 40".

As illustrated in Fig. 6(b), boundaries between the first and second wiring portions 41 and 42 and both ends 40a and 40b of the functional portion 40 may not be clear.

### (Common second modification)

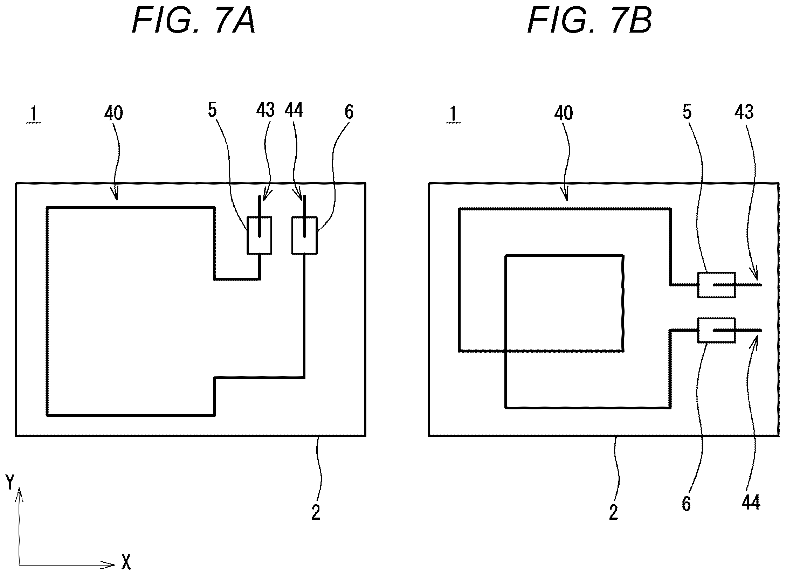

In the first and second embodiments, the electrode pads 5 and 6 are aligned in the Y direction along one side of the film 2 parallel to the Y direction. However, the electrode pads 5 and 6 may be aligned in the X direction at the peripheral edge portion of the film 2 as illustrated in Fig. 7(a). More specifically, the electrode pads 5 and 6 are aligned in the X direction along one side of the film 2 parallel to the X direction.

In addition, when the conductive wire 9 having the insulating coating layer 8 is used for the circuit 4, the conductive wire 9 can be crossed, for example, as illustrated in Fig. 7(b), so that the circuit 4 including the functional portion 40 can have a complicated pattern shape.

The number of electrode pads is not limited to two.

### (Embedded trace substrate-integrated molded article)

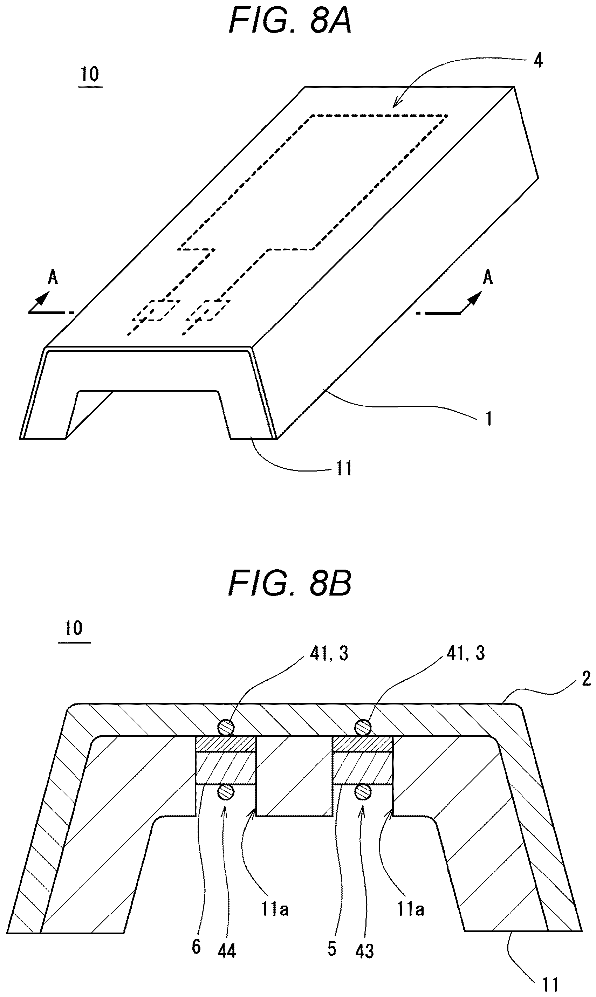

Referring to Fig. 8, an embedded trace substrate-integrated molded article 10 according to the present embodiment includes a molded body 11 having a three-dimensional shape and an embedded trace substrate 1 integrated along the three-dimensional shape and having at least two electrode pads 5 and 6 exposed from the molded body 11. The molded body 11 has a three-dimensional shape, in other words, a 3D shape. The embedded trace substrate 1 is integrated along the 3D shape of the molded body 11. The two electrode pads 5 and 6 of the embedded trace substrate 1 and the folded-back portions 43 and 44 connected to the upper surfaces 5a and 6a of the electrode pads 5 and 6 are exposed from openings 11a of the molded body 11. Since the electrode pads 5 and 6 are exposed from the molded body 11, the electrode pads 5 and 6 can be easily connected to external wires (not illustrated).

The embedded trace substrate-integrated molded article 10 can be manufactured, for example, by bonding the embedded trace substrate 1 to the molded body 11 provided with the openings 11a or by insert molding.

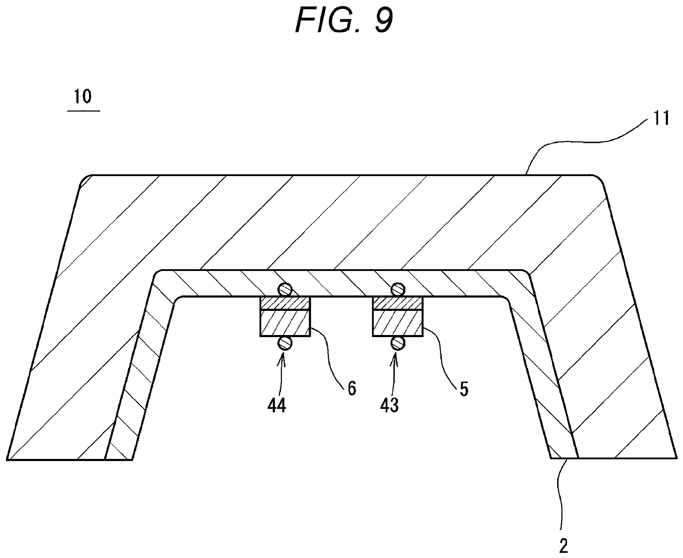

As illustrated in Fig. 9, the embedded trace substrate-integrated molded article 10 may be configured such that the entire surface of the embedded trace substrate 1 on which the electrode pads 5 and 6 are formed is exposed from the molded body 11 without having the openings 11a illustrated in Fig. 8 in the molded body 11.

### (Production method for embedded trace substrate)

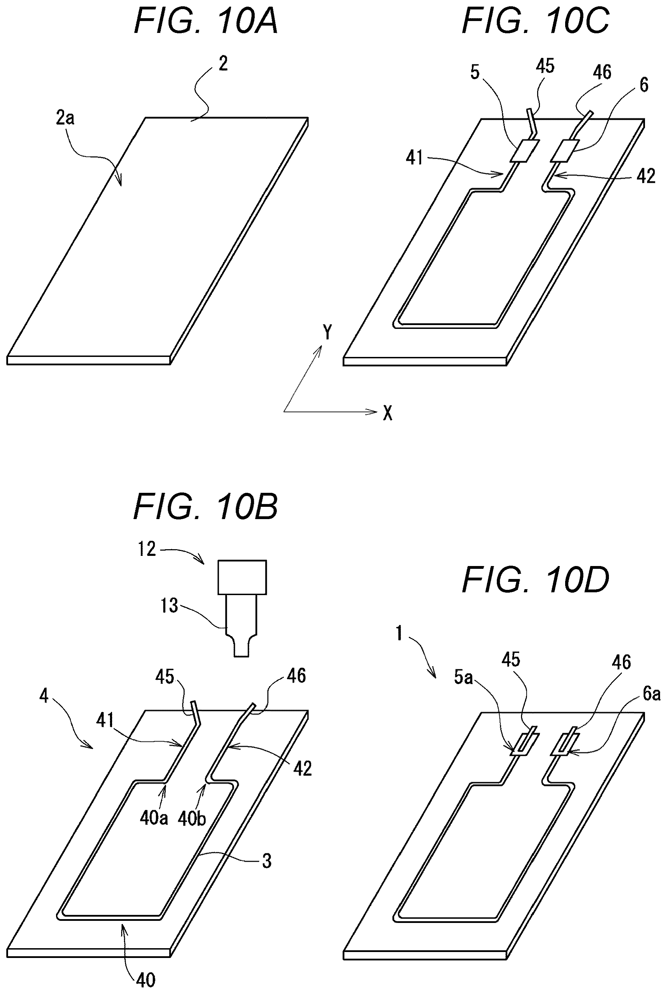

Referring to Fig. 10, the production method for an embedded trace substrate 1 includes a preparation step (Fig. 10(a)) of preparing a film 2, a circuit formation step (Fig. 10(b)) of forming a circuit 4 using an ultrasonic welding machine 12, a fixing step (Fig. 10(c)) of fixing electrode pads 5 and 6, and a connection step (Fig. 10(d)) of electrically connecting a first end portion 45 and a second end portion 46 to the electrode pads 5 and 6.

In the preparation step, the film 2 may be fixed on a stage (not illustrated). In addition, a jig (not illustrated) may be used to facilitate alignment of the film 2.

Referring to Fig. 10(b), the ultrasonic welding machine 12 used in the circuit formation step includes an oscillator (not illustrated) that generates ultrasonic vibration, and a horn 13 that propagates the ultrasonic vibration from the oscillator. By simultaneously applying ultrasonic vibration and pressure, a region of the film 2 with which the thin metal wire 3 is in contact is melted and instantly bonded.

The circuit 4 includes one thin metal wire 3. The circuit 4 has a shape illustrated in Fig. 10(b) and includes a functional portion 40 having an arbitrary pattern, a first wiring portion 41 led out from one end 40a of both ends of the functional portion 40, a second wiring portion 42 led out from another end 40b of both ends of the functional portion 40, and the first end portion 45 and the second end portion 46 extending in a direction away from the functional portion 40 from the first wiring portion 41 and the second wiring portion 42, respectively. Such a circuit 4 is disposed on a first main surface 2a of the film 2, and the functional portion 40, the first wiring portion 41, and the second wiring portion 42 are embedded in the first main surface 2a using the ultrasonic welding machine 12. At this time, the first end portion 45 and the second end portion 46 are not embedded in the film 2.

Temporarily fixing the circuit 4 on the first main surface 2a of the film 2 can prevent positional displacement upon the embedding process.

The circuit 4 may be embedded in the first main surface 2a of the film 2 by the ultrasonic welding machine 12 while feeding the thin metal wire 3 from a feeding device (not illustrated). For example, the thin metal wire 3 to be the first end portion 45 is fed, the terminal point of the thin metal wire 3 that has been fed is embedded, and the first wiring portion 41, the functional portion 40, and the second wiring portion 42 can be embedded in this order while feeding the thin metal wire 3.

Referring to Fig. 10(c), in the fixing step, the first electrode pad 5 is fixed on the first wiring portion 41, and the second electrode pad 6 is fixed on the second wiring portion 42. Each of the electrode pads 5 and 6 can be fixed using an adhesive layer 7 (see Fig. 1(b)). The fixing position of the first electrode pad 5 in the X direction is a position where the first wiring portion 41 overlaps the center of the first electrode pad 5 in the width direction (X direction) in plan view, and the fixing position in the Y direction is a position where the first end portion 45 overlaps the upper surface 5a of the first electrode pad 5 in plan view when the first end portion 45 is folded back.

Referring to Fig. 10(d), in the connection step, the first end portion 45 and the second end portion 46 are folded back to the upper surfaces 5a and 6a of the electrode pads 5 and 6 so as to be parallel to the first main surface 2a of the film 2. Since it is only necessary to fold back the first and second end portions 45 and 46 "so as to be parallel", it is not necessary to fold back the end portions 45 and 46 to be completely parallel.

After being folded back, the first end portion 45 and the second end portion 46 are electrically connected to the electrode pads 5 and 6, respectively. Welding (resistance welding, ultrasonic welding, laser welding, etc.), soldering, brazing, and the like, which are known metal bonding techniques, can be used for the connection.

In this way, the embedded trace substrate 1 can be obtained.

In the production method for the embedded trace substrate 1 according to the present embodiment, the thin metal wire 3 is embedded in the first main surface 2a of the film 2, and then, the electrode pads 5 and 6 are arranged, and the first end portion 45 and the second end portion 46 not embedded in the film 2 are folded back and electrically connected to the upper surfaces 5a and 6a of the electrode pads 5 and 6. That is, stress is less likely to be applied to the first end portion 45 and the second end portion 46 connected to the upper surfaces 5a and 6a of the electrode pads 5 and 6. Therefore, even if the film 2 shrinks, the connection portion is less likely to peel off, whereby the conductivity is less likely to decrease.

In addition, by folding back the first end portion 45 and the second end portion 46 without being embedded in the first main surface 2a of the film 2, the first end portion 45 and the second end portion 46 are positioned on the upper surfaces 5a and 6a of the electrode pads 5 and 6, so that working efficiency of electrical connection is improved.

### (Another example of production method)

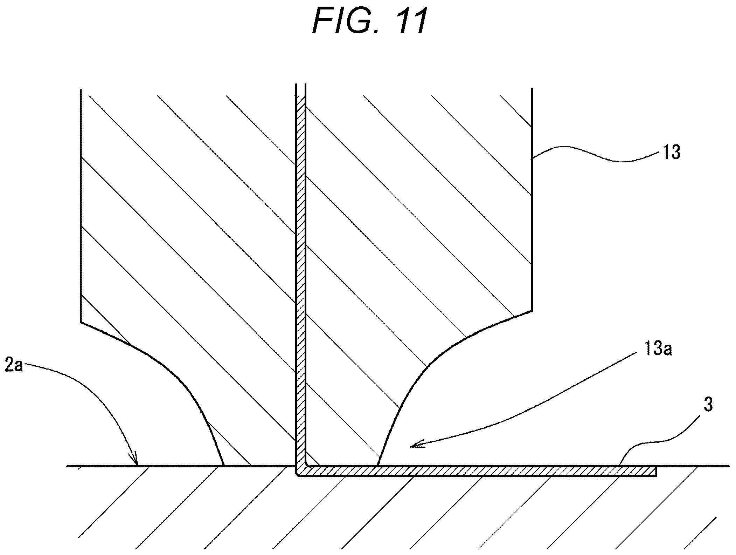

The ultrasonic welding machine 12 may include a horn 13 and a thin metal wire 3. Referring to Fig. 11, the horn 13 can melt a contact surface of the film 2 with the thin metal wire 3 and also embed the thin metal wire 3 in the first main surface 2a of the film 2 by applying ultrasonic vibration. The thin metal wire 3 passes through the inside of the horn 13 and is continuously drawn out from a tip 13a of the horn 13 onto the first main surface 2a of the film 2.

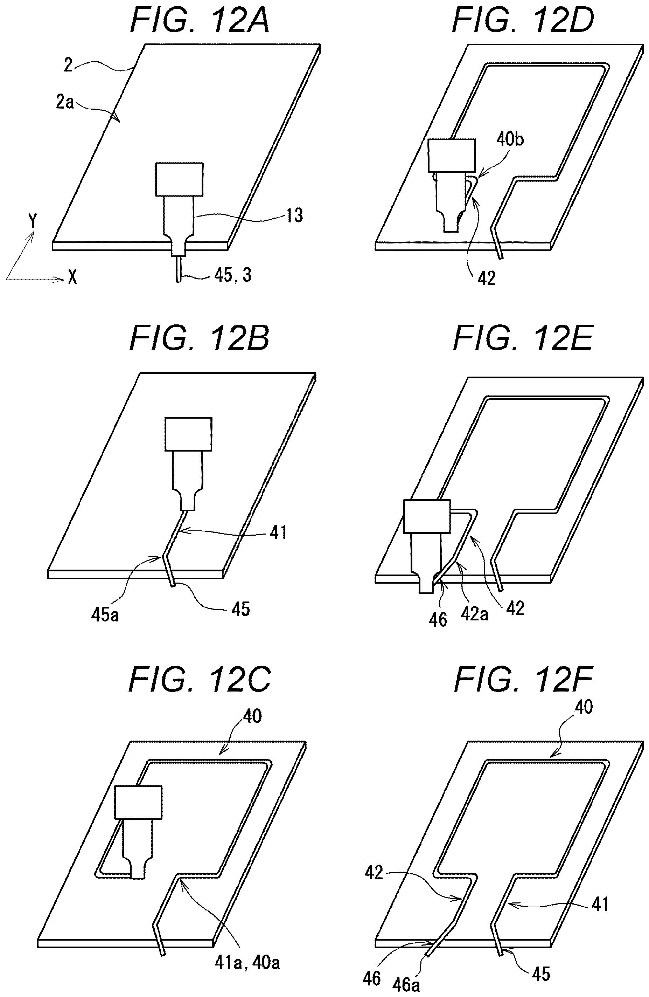

A circuit formation step using the horn 13 described above will be described with reference to Fig. 12. First, as illustrated in Fig. 12(a), the thin metal wire 3 is drawn out from the horn 13 by a predetermined length to form a first end portion 45. That is, the predetermined length of the thin metal wire that has been drawn out is defined as the length of the first end portion 45.

Next, as illustrated in Fig. 12(b), the thin metal wire 3 is further drawn out by a predetermined length in the +Y direction from an end point 45a of the first end portion 45 that has been drawn out, and is embedded in the first main surface 2a of the film 2, by which the first wiring portion 41 is formed.

Next, as illustrated in Fig. 12(c), the thin metal wire 3 is drawn out by a predetermined length from an end point 41a of the first wiring portion 41 that has been embedded, and is embedded in the first main surface 2a of the film 2 in an arbitrary pattern extending in the XY plane, by which a functional portion 40 is formed. The end point 41a of the first wiring portion 41 that has been embedded serves as a starting point of the functional portion 40. In other words, the end point 41a serves as one end 40a of both ends of the functional portion 40 (see Fig. 1(a)).

Next, as illustrated in Fig. 12(d), the thin metal wire 3 is drawn out by a predetermined length from the horn 13 so as to extend in the -Y direction from an end point 40b of the functional portion 40, and is embedded in the first main surface 2a of the film 2, by which a second wiring portion 42 is formed. The end point 40b of the functional portion 40 serves as a starting point of the second wiring portion 42.

Next, as illustrated in Fig. 12(e), the thin metal wire 3 is drawn out by a predetermined length from an end point 42a of the second wiring portion 42 that has been embedded to form a second end portion 46 that is not embedded in the film 2. That is, the predetermined length of the thin metal wire that has been drawn out is defined as the length of the second end portion 46.

Finally, as illustrated in Fig. 12(f), the thin metal wire 3 is cut at an end point 46a of the second end portion 46 that has been drawn out. As a cutting method, for example, a cutter or a nipper can be used.

According to such a production method, the circuit 4 can be formed in a so-called one-stroke manner. In addition, since the thin metal wire 3 can be placed and embedded at the same time, the circuit 4 can be formed with higher positional accuracy.

In the circuit formation step described with reference to Figs. 10 and 12, the conductive wire 9 obtained by coating the thin metal wire 3 with the insulating coating layer 8 may be used. The connection step using the conductive wire 9 can be performed as follows. First, the first end portion 45 and the second end portion 46 are folded back such that the insulating coating layer 8 at the first end portion 45 and the second end portion 46 is in contact with the upper surfaces 5a and 6a of the electrode pads 5 and 6. Next, the insulating coating layer 8 at the first end portion 45 and the second end portion 46 is melted by heat to fully expose the thin metal wire, and the exposed thin metal wire 3 is electrically connected to the upper surfaces 5a and 6a of the electrode pads 5 and 6. As a method for melting the insulating coating layer 8 by heat, welding (resistance welding, ultrasonic welding, laser welding, etc.), soldering, brazing, or the like can be used.

The connection step using the conductive wire 9 can also be performed as follows. First, a part of the insulating coating layer 8 at the first end portion 45 and the second end portion 46 is removed in advance. Examples of a method for removal include removing by cutting, removing by heat melting, and removing using chemicals. Next, the first end portion 45 and the second end portion 46 are folded back so as to be in contact with the upper surfaces 5a and 6a of the electrode pads 5 and 6. When the insulating coating layer 8 is completely removed, the exposed thin metal wire 3 is electrically connected to the upper surfaces 5a and 6a of the electrode pads 5 and 6 using the conductive joint material 14 as illustrated in Fig. 3(a). When the insulating coating layer 8 is partly removed, the conductive wire 9 is covered with the conductive joint material 14 (see Fig. 3(b)) or the conductive joint material 14 is formed between the exposed thin metal wire 3 and the electrode pads 5 and 6 (see Fig. 3(c)) to electrically connect the thin metal wire 3 with the electrode pads 5 and 6.

According to this method, a part of the insulating coating layer 8 at the first end portion and the second end portion is removed in advance, whereby the thin metal wire 3 and the electrode pads 5 and 6 can be electrically connected more reliably and easily.

### Reference Signs List

- 1:: embedded trace substrate
- 2:: film
- 2a:: first main surface
- 3:: thin metal wire
- 4:: circuit
- 40:: functional portion
- 41:: first wiring portion
- 42:: second wiring portion
- 43:: first folded-back portion
- 44:: second folded-back portion
- 45:: first end portion
- 46:: second end portion
- 5:: first electrode pad
- 6:: second electrode pad
- 5a,: 6a: upper surface
- 7:: adhesive layer
- 8:: insulating coating layer
- 9:: conductive wire
- 10:: embedded trace substrate-integrated molded article
- 11:: molded body
- 11a:: opening
- 12:: ultrasonic welding machine
- 13:: horn
- 14:: conductive joint material
- 15:: first circuit
- 151:: first functional portion
- 152:: first wiring portion
- 153:: second wiring portion
- 154:: first folded-back portion
- 155:: second folded-back portion
- 16:: second circuit
- 161:: second functional portion
- 162:: third wiring portion
- 163:: fourth wiring portion
- 164:: third folded-back portion
- 165:: fourth folded-back portion
- 100:: film heater
- 200:: film
- 300:: thin metal wire
- 400:: circuit
- 410:: connection terminal portion
- 420:: wiring portion
- 430:: heater portion
- 500:: electrode pad
- 600:: electrode pad
- 700:: adhesive layer
- 800:: joining layer
- 900:: weld portion

## Claims

1. An embedded trace substrate comprising:
a film;
a circuit that includes a thin metal wire disposed on a first main surface of the film and that has a functional portion having an arbitrary pattern, a first wiring portion led out from one end of both ends of the functional portion, a second wiring portion led out from another end of both ends of the functional portion, and folded-back portions extending in a direction away from the functional portion from the first wiring portion and the second wiring portion, respectively, and folded back so as to be parallel to the first main surface of the film, the functional portion, the first wiring portion, and the second wiring portion being embedded in the film; and
two electrode pads respectively fixed on the first wiring portion and the second wiring portion and having upper surfaces to which the folded-back portions are electrically connected.

2. An embedded trace substrate comprising:
a film;
two circuits each including a thin metal wire disposed on a first main surface of the film, the two circuits including a first functional portion and a second functional portion, respectively, which are arranged in parallel to each other and each of which has an arbitrary pattern, a first wiring portion led out from one end of both ends of the first functional portion, a second wiring portion led out from another end of both ends of the first functional portion, a third wiring portion led out from one end of both ends of the second functional portion, a fourth wiring portion led out from another end of both ends of the second functional portion, and a first folded-back portion, a second folded-back portion, a third folded-back portion, and a fourth folded-back portion that extend from the first wiring portion, the second wiring portion, the third wiring portion, and the fourth wiring portion, respectively, in a direction away from the first functional portion and the second functional portion, and that are folded back so as to be parallel to the first main surface of the film, the first functional portion, the second functional portion, the first wiring portion, the second wiring portion, the third wiring portion, and the fourth wiring portion being embedded in the film;
a first electrode pad fixed on both the first wiring portion and the third wiring portion and having an upper surface to which the first folded-back portion and the third folded-back portion are electrically connected; and
a second electrode pad fixed on both the second wiring portion and the fourth wiring portion and having an upper surface to which the second folded-back portion and the fourth folded-back portion are electrically connected.

3. The embedded trace substrate according to claim 2, wherein end portions respectively extending from the first wiring portion and the third wiring portion or end portions respectively extending from the second wiring portion and the fourth wiring portion are joined to each other.

4. The embedded trace substrate according to any one of claims 1 to 3, wherein
the thin metal wire is covered with an insulating coating layer,
the thin metal wire at the folded-back portions is fully exposed, and the thin metal wire that is exposed is electrically connected to the electrode pads.

5. The embedded trace substrate according to any one of claims 1 to 3, wherein
the thin metal wire is covered with an insulating coating layer,
the thin metal wire is exposed from a part of the insulating coating layer at the folded-back portions, and the thin metal wire that is exposed is electrically connected to the electrode pads using a conductive joint material.

6. An embedded trace substrate-integrated molded article comprising:
a molded body having a three-dimensional shape; and
the embedded trace substrate according to any one of claims 1 to 3, the embedded trace substrate being integrated along the three-dimensional shape and including at least two of the electrode pads exposed from the molded body.

7. A production method for an embedded trace substrate, the method comprising:
a preparation step of preparing a film;
a circuit formation step of forming a circuit that includes a thin metal wire disposed on a first main surface of the film and that has a functional portion having an arbitrary pattern, a first wiring portion led out from one end of both ends of the functional portion, a second wiring portion led out from another end of both ends of the functional portion, and a first end portion and a second end portion that extend in a direction away from the functional portion from the first wiring portion and the second wiring portion, respectively, the functional portion, the first wiring portion, and the second wiring portion being embedded in the first main surface of the film using an ultrasonic welding machine;
a fixing step of fixing electrode pads on the first wiring portion and the second wiring portion, respectively; and
a connection step of folding back the first end portion and the second end portion to upper surfaces of the electrode pads so as to be parallel to the first main surface of the film and electrically connecting the first end portion and the second end portion to the electrode pads.

8. The production method for an embedded trace substrate according to claim 7, wherein
the ultrasonic welding machine includes a horn that applies ultrasonic vibration to melt a contact surface of the film with the thin metal wire and embed the thin metal wire in the first main surface of the film, and the thin metal wire that passes through an inside of the horn and is continuously drawn out from a tip of the horn onto the first main surface of the film, and
the circuit formation step includes:
a step of drawing out the thin metal wire by a predetermined length from the horn as the first end portion that is not embedded in the film;
a step of forming the first wiring portion by further drawing out the thin metal wire by a predetermined length from an end point of the first end portion that has been drawn out and embedding the thin metal wire in the first main surface of the film;
a step of forming the functional portion by drawing out the thin metal wire from the horn by a predetermined length and embedding, in an arbitrary pattern, the thin metal wire in the first main surface of the film from an end point of the first wiring portion that has been embedded;
a step of forming the second wiring portion by drawing out the thin metal wire from the horn by a predetermined length and embedding the thin metal wire which extends from an end point of the functional portion that has been embedded in the first main surface of the film;
a step of drawing out the thin metal wire by a predetermined length from an end point of the second wiring portion that has been embedded as the second end portion that is not embedded in the film; and
a step of cutting the thin metal wire at an end point of the second end portion that has been drawn out.

9. The production method for an embedded trace substrate according to claim 7 or 8, wherein
the thin metal wire used in the circuit formation step is covered with an insulating coating layer, and
the connection step includes:
a step of folding back the first end portion and the second end portion so that the insulating coating layer at the first end portion and the second end portion is in contact with the upper surfaces of the electrode pads; and
a step of melting the insulating coating layer at the first end portion and the second end portion by heat to fully expose the thin metal wire and electrically connecting the thin metal wire that has been exposed with the upper surfaces of the electrode pads.

10. The production method for an embedded trace substrate according to claim 7 or 8, wherein
the thin metal wire used in the circuit formation step is covered with an insulating coating layer, and
the connection step includes:
a step of removing a part of the insulating coating layer at the first end portion and the second end portion in advance;
a step of folding back the first end portion and the second end portion so that the first end portion and the second end portion are in contact with the upper surfaces of the electrode pads; and
a step of electrically connecting the thin metal wire with the electrode pads using a conductive joint material.
